# EUROPEAN PATENT APPLICATION

(11) **EP 1 085 563 A2**
(43) Date of publication of application: **21.03.2001**
(21) Application number: 00119753.2
(22) Date of filing: 11.09.2000
(51) Int. Cl.: H01L 21/311, H01L 21/314

(54) **Process for etching an insulating layer and forming a semiconductor device**

(30) Priority: 13.09.1999 US 394517
(71) Applicant: MOTOROLA, INC., Schaumburg, IL 60196 (US)
(72) Inventor: Rajagopalan, Ganesh, Austin, Texas 78746 (US)
(74) Representative: Gibson, Sarah Jane

(57) **Abstract**

Many variations of etches for insulating layers (114, 400, 422, 426) can be used. In one set of embodiments, an insulating layer (114, 400, 422, 426) is etched using an oxide etching component, a fluorine-scavenging component, and an organic etching component. In another set of embodiments, the insulating layer (114, 400, 422, 426) includes at least one atomic weight percent of carbon or hydrogen. That insulating layer is etched using an oxide etching gas and a nitrogen-containing gas. In yet another set of embodiments, an insulating layer (114, 400, 422, 426) is formed over semiconductor device substrate (100) having a diameter of at least approximately 300 millimeters. The insulating layer (114, 400, 422, 426) is etched using an oxide etching gas and a nitrogen-containing gas.

## Description

### Field of the Invention

The present invention relates generally to processes for forming semiconductor devices, and more particularly, to etch processes used in forming semiconductor devices.

### Related Art

Modern semiconductor devices are more likely to use low-k dielectric materials for interlevel dielectrics to reduce problems, such as cross talk, unintended capacitance between conductors, and improved performance. Materials used for low-k dielectrics typically include polymer films or silica-based films. As used in this specification, low-k dielectrics are dielectrics having a dielectric constant no higher than approximately 3.5. Traditionally, silicon dioxide has been used as a dielectric material and has a dielectric constant of approximately 3.9. Typically when etching silica-based materials, the etching process stops on an etch-stop layer such as silicon nitride, silicon-rich silicon nitride or other similar materials.

Newer low-k dielectrics that are silica-based include fluorine-doped oxides and oxides that include carbon and hydrogen. Etching these silica-based, low-k dielectric materials becomes particularly difficult when the hydrogen or both carbon and hydrogen are present in the silica-based film. When etching these materials, they need to be etched selectively to silicon nitride. Otherwise, an electrical short in a self-aligned contact or the formation of metallic veils (copper or aluminum) may occur.

Traditional silicon dioxide etch processes do not work well, particularly for the organic silica-based films (OSG). Generally, octofluorobutene (C₄F₈) and carbon monoxide (CO) have been used for etching silicon dioxide films selective to silicon nitride. However, this etch chemistry will not effectively etch the carbon and hydrogen that is present within the OSG films. Molecular nitrogen (N₂) has been added to trifluoromethane (CHF₃) and carbon tetrafluoride (CF₄) gases during an oxide etch. In that particular embodiment, the ratio of nitrogen to the total fluorocarbon compounds is believed to be approximately 1:2. This chemistry is tailored specifically for high aspect ratio openings for traditional oxides (hydrogen or carbon level much less than one atomic percent). The level of nitrogen present may not be sufficient to remove the hydrogen and carbon seen with typical organic silica-based dielectrics.

### Brief Description of the Drawings

The present invention is illustrated by way of example and not limitation in the accompanying figures, in which like references indicate similar elements, and in which:
FIG. 1 includes an illustration of a cross-sectional view of a portion of a semiconductor device after forming gate electrodes and a low-k dielectric material;
FIG. 2 includes an illustration of a cross-sectional view of the substrate of FIG. 1 after etching a contact opening;
FIG. 3 includes an illustration of a cross-sectional view of the substrate of FIG. 2 after forming a conductive plug within the opening;
FIG. 4 includes an illustration of a cross-sectional view of the substrate of FIG. 3 after forming an interconnect and another set of interlevel dielectric layers;
FIG. 5 includes an illustration of a cross-sectional view of the substrate of FIG. 4 after forming via opening portions for a dual inlaid opening;
FIG. 6 includes an illustration of a cross-sectional view of the substrate of FIG. 5 after forming a dual inlaid opening; and
FIG. 7 includes an illustration of a cross-sectional view of the substrate of FIG. 6 after forming a substantially completed device.

Skilled artisans appreciate that elements in the figures are illustrated for simplicity and clarity and have not necessarily been drawn to scale. For example, the dimensions of some of the elements in the figures may be exaggerated relative to other elements to help improve the understanding of the embodiments of the present invention.

### Detailed Description

Many variations of etches for insulating layers can be used. In one set of embodiments, an insulating layer is etched using an oxide etching component, a fluorine-scavenging component, and an organic etching component. In another set of embodiments, the insulating layer includes at least one atomic weight percent of carbon or hydrogen. That insulating layer is etched using an oxide etching gas and a nitrogen-containing gas. In still another set of embodiments, an insulating layer is formed over semiconductor device substrate having a diameter of at least approximately 300 millimeters. The insulating layer is etched using an oxide etching gas and a nitrogen-containing gas. The present invention is defined by the claims and is better understood after reading the descriptions of the embodiments below.

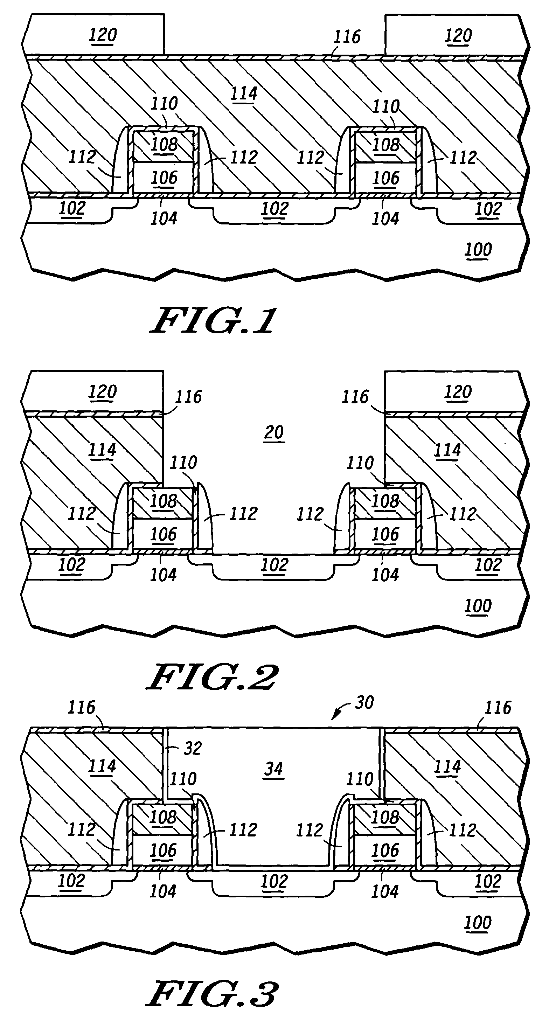

FIG. 1 includes an illustration of a cross sectional view of a semiconductor device at an intermediate portion of processing. Referring to FIG. 1, a semiconductor device substrate 100 includes doped regions 102 that are source, drain or source/drain regions. As used in this specification, a semiconductor device substrate includes a monocrystalline semiconductor wafer, a semiconductor-on-insulator wafer, or any other substrate used in forming semiconductor devices. The semiconductor device substrate has a diameter of approximately 200 millimeters (mm), although other sizes, such as 300 mm or even larger, can be used. A gate dielectric layer 104 overlies portions of the semiconductor device substrate 100 and regions 102. A gate electrode layer 106 overlies the gate dielectric layer 104 and a capping layer 108 overlies the gate electrode 106. Typically, the capping layer 108 includes silicon nitride or other similar material. After forming those elements, a liner layer 110 is then formed over the doped regions and portions of the gate electrode stacks. The liner layer 110 is typically an oxide. Sidewall spacers 112 are formed along the vertical sidewall portions of the gate electrode structures immediately adjacent to the liner layer 110. In this embodiment, the sidewall spacers 112 are made of silicon nitride.

A first interlevel dielectric layer 114 is then formed over the liner layer 110 and spacers 112. The first interlevel dielectric layer 114 typically is a silica-based material that includes either hydrogen or hydrogen and carbon. Typically, the atomic weight percent of the hydrogen or the carbon and hydrogen is at least approximately 5 atomic % and could be as high as approximately 20 atomic %. At this level, the silica-based film etches significantly different from a traditional silicon dioxide film. Although tetraethylorthosilicate-based (TEOS-based) oxides include carbon and hydrogen, a silicon dioxide film formed from TEOS will typically have much less than one atomic percent carbon and hydrogen composition within the film. Therefore, the organic silica-based films have a much higher level of hydrogen and carbon within them, for example, approximately 5-20 atomic percent hydrogen or combined hydrogen and carbon. The dielectric constant of this film is typically in a range of approximately 2.7-3.5, when only hydrogen is added. If both carbon and hydrogen are added to approximately 10 atomic percent, the dielectric constant is in a range of approximately 2.5-2.8. The first ILD layer 114 can be formed by a spin-on method or by chemical vapor deposition. After a planarized first interlevel dielectric layer has been formed, a capping layer 116 is typically formed overlying it. The capping layer 116 is typically a silicon dioxide film however, other films can be used if desired. A photoresist layer 120 is then formed and patterned where a contact opening will be formed.

An etch is performed to remove portions of the capping layer 116, the first ILD layer 114, and the liner layer 110 to form contact opening 20 as shown in FIG. 2. The etch chemistry used to etch the first ILD layer 114 typically includes at least one species that includes carbon and fluorine (fluorocarbon species). This etching species is the primary oxide etchant component for the silica within the low-k dielectric material. Additionally, the etch chemistry includes a fluorine scavenging component to improve selectivity to nitride and an organic etchant, which is used to etch the carbon and hydrogen within the first ILD layer. In one specific embodiment, the chemistry can include octofluorobutene (C₄F₈) as the silica etchant, carbon monoxide (CO) as a fluorine- scavenging component, and molecular nitrogen gas as an organic etching component. CO helps to improve the selectivity to nitride and nitrogen gas reacts with carbon and hydrogen to form hydrogen cyanide (HCN), which evolves as a gas.

The first ILD layer 114 has a capability of being etched selective to the silicon nitride in both the capping layer 108 and the sidewall spacers 112 such that a relatively small (insignificant) portion is removed. Selectivities of oxide:nitride removal using this etch typically are at least 5:1 and more commonly are in a range of approximately 6:1 to 25:1. In one particular embodiment, octofluorobutene flows at approximately 10 standard cubic centimeters per minute (sccm), carbon monoxide flows approximately 400 sccm, and molecular nitrogen gas flows at approximately 100 sccm. In this particular embodiment, the gas flow rates are used for a 200 mm diameter wafer. If different wafer sizes are used, generally the flow rates will need to be adjusted. A simple conversion would be to take the size the diameter of the substrate (in millimeters) to be etched divided by 200 then raised to a power in a range of approximately 1.5 to 2.5. In this manner, the gas flow rates can be adjusted for a variety of wafer sizes.

In other embodiments, the carbon monoxide flow may be adjusted to approximately 100 sccm, and the nitrogen flow held constant at approximately 100 sccm. In still another embodiment, the flow rates of carbon monoxide and nitrogen can be increased beyond those previously listed. When the flow rate of carbon monoxide is approximately 500 standard cubic centimeters per minute and the nitrogen is at approximately 200 standard cubic centimeters per minute, etch selectivities as high as 25:1 may be achieved. Even higher selectivities may be possible with further optimization of the gas flow rates.

The gas ratio of the nitrogen gas to octofluorobutene is typically at least approximately 1:1, and more commonly is in a range of approximately 5:1 to 20:1. In terms of gas ratios between the carbon monoxide and molecular nitrogen, a gas flow ratio of one part carbon monoxide to one part of nitrogen gas up to at least 4:1 are desired. In general, the selectivity improves as the amount of carbon monoxide increases. However, if the relative portion of nitrogen is reduced too much with respect to carbon monoxide, some of the hydrocarbon etching that is seen by using nitrogen gas may decrease. Therefore, although no lower limit of the ratio of the carbon monoxide to nitrogen is known, there becomes a point at which etching the hydrocarbon will be too slow. Other than the gas flows and ratios, all other etching parameters are expected to be those as conventionally used within the industry.

Other silica containing species can be used. Ideally, the silica etching species should have no hydrogen atoms. Examples include carbon tetrafluoride (CF₄), hexafluoroethane (C₂F₆), hexafluoropropene(C₃F₆), and octofluoropentadiene (C₅F₈). Still, the silica etching species can include some hydrogen, such as trifluoromethane (CHF₃).

In other embodiments carbon monoxide may not be required to etch the ILD layer 114, if the nitride layers 108 and 112 are substantially thick enough. In these particular embodiments, it could be that only a fluorocarbon etching species and molecular nitrogen are being used. In this case, the ratio of the fluorocarbon to nitrogen should be at least 1:1 and typically will be in a range of 5 parts of nitrogen gas to 1 part fluorocarbon up to approximately 20 parts nitrogen gas to one part fluorocarbon. In yet another embodiment, either one or both of the carbon monoxide and nitrogen gases may be replaced with nitrous oxide (N₂0). If nitrous oxide is used, it can potentially be a fluorine scavenger similar to carbon monoxide. Because nitrogen should be present when N₂0 breaks down, it is possible that nitrogen in the plasma can be an organic etchant to react with the carbon and hydrogen within the silica-based material.

Although not disclosed, each of these etch chemistries given typically will also include noble gas, such as argon, helium, neon, or the like. Depending on the process chamber dynamics, the inert gas helps in controlling chamber pressure, compensating for residence time and improving etch rate uniformity.

The capping layer 116 and the oxide liner layer 110 can be etched using the same etch chemistry used in etching the first ILD layer 114 or can be etched using more traditional oxide etched chemistries.

In still another embodiment, multiple steps can be performed to create the contact opening 20. In one embodiment, an appropriate fluorocarbon species can be used in combination with nitrogen for etching most of the capping layer 116 and the first ILD layer 114 and then towards the end of the etch, the process is switched to a selective chemistry that would include the low fluorine to carbon ratio gas, nitrogen and carbon monoxide.

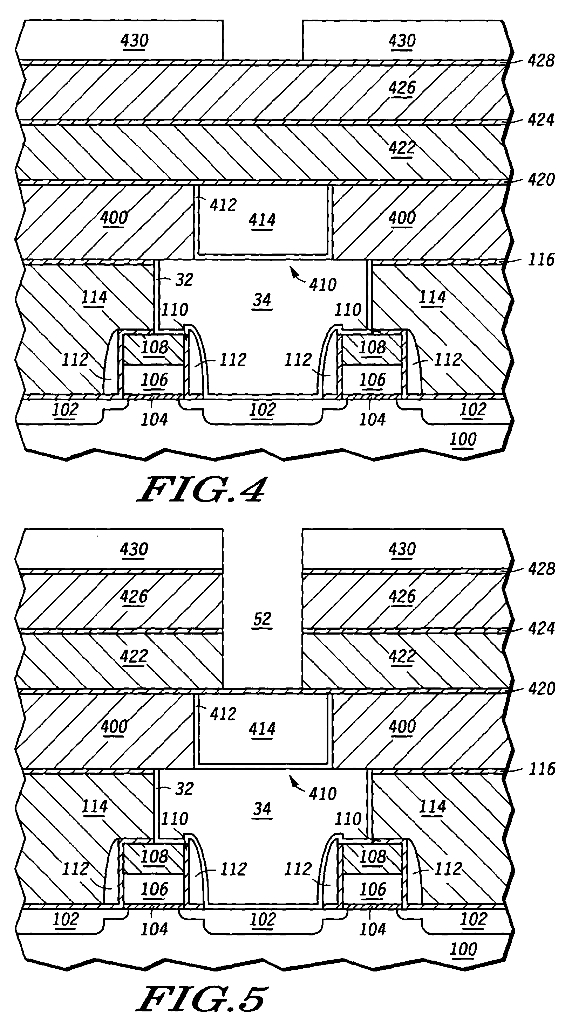

A contact plug 30 is then formed within the contact opening as shown in FIG. 3. The contact plug is formed using a barrier film 32 and a conductive fill material 34. In one particular embodiment, the barrier film 32 includes titanium, titanium nitride, tantalum, tantalum nitride, other refractory metals, their corresponding nitrides, or combinations thereof. The conductive fill material 34 is typically tungsten, however, in some embodiments, aluminum or possibly copper could also be used.

A first interconnect level is formed by forming a second ILD layer 400 and forming an interconnect trench that contacts the conductive plug as shown in FIG. 4. The second ILD layer 400 typically is formed of a similar material as a first ILD layer 114. After etching the second ILD layer 400 using any of the etching conditions that were described for etching the first ILD layer 114, the interconnected trench is then filled with a barrier film 412 and a conductive fill material 414. After polishing, the interconnect 410 is formed as shown in FIG. 4. The barrier film 412 can be any one or more of the materials listed with respect to barrier film 32. In this particular embodiment, the conductive fill material 414 is typically copper, aluminum, tungsten or the like.

A second set of films is formed for making a dual-inlaid opening that will be formed. A nitride capping layer 420 is formed to keep the copper 414 within the interconnect 410. A third ILD layer 422 and an etch-stop layer 424, a fourth ILD layer 426, and a capping layer 428 are sequentially formed. The capping layer 428 is similar to the capping layer 116 as described in conjunction with FIG. 1. The interlevel dielectric layers 422 and 426 are similar to those described with respect to the first interlevel dielectric layer 114. Typically, the layers 420 and 424 are insulating layers. The etch-stop layer 424 is typically formed of a nitride layer, such as silicon nitride, and the capping layer 420 is also formed of silicon nitride or the like. A photoresist layer 430 is then formed and patterned to correspond to the shape of a via portion for a dual inlaid opening.

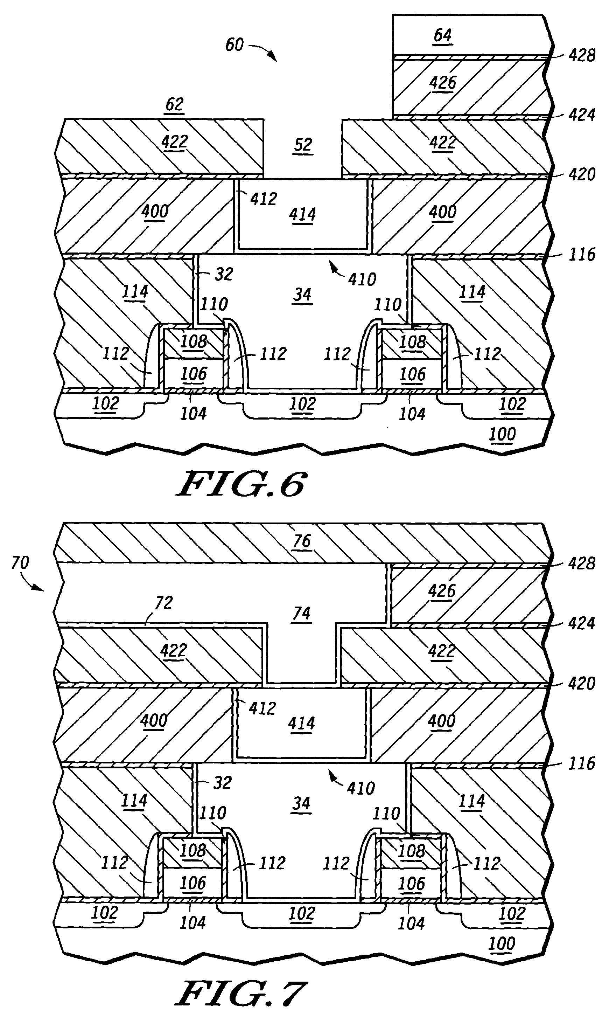

Referring to FIG. 5, an etch is then performed to create the via 52 portion that extends through layers 422 through 428. The etch stops on the capping layer 420 to prevent possible via veil formation from occurring. The via veils could be formed if the plasma etch chemistry used in forming the via portion 52 would extend such that it contacts the conductive fill material 414. The etch chemistries previously described regarding first ILD layer 114 can be used in etching layers 422 and 426. The etch chemistry will change when etching through the nitride etch-stop layer 424 and may change before reaching the capping layer 420.

After removing the photoresist layer 430, another photoresist layer 64 is formed over the capping layer 428 and patterned to correspond to the interconnect opening. Referring to FIG. 6, an etch is then performed to form the dual inlaid interconnect opening 60, which includes an interconnect trench portion 62 and the via portion 52. Typically the etch will be performed to remove the capping layer 428 and the fourth ILD layer 426, stopping on the etch-stop film 424. A subsequent portion of the etch uses a nitride etch chemistry to remove both the etch-stop film 424 and the capping layer 420 within the dual inlaid opening. Because the etching of the capping layer 420 and etch-stop layer 424 are performed at a lower power compared to an oxide etch, the likelihood of forming via veils is decreased.

Processing is continued to form a substantially complete device as shown in FIG. 7. A barrier film 72 is first formed following by a conductive fill material 74. The materials listed for use with respect to interconnect 410 can be used at this level. A polishing step is used to remove the portions of film 72 and material 74 lying outside of the dual inlaid opening. This forms the interconnect 70 as illustrated in FIG. 7. A passivation layer 76 is then formed over the uppermost level of interconnects to form a substantially completed device.

The various embodiments of the present invention include many benefits. One of the biggest benefits is allowing a reasonable etch rate for silica-based, organic-containing material for low-k dielectrics. A combination of the fluorocarbons and nitrogen-containing etching chemistry allows etching of both silica and hydrocarbons. Again, the fluorine from the fluorocarbons etches the silicon dioxide, the nitrogen-containing material allows for etching of the hydrocarbon material within the low-k dielectric material. The addition of carbon monoxide helps the selectivity to other layers, in particular silicon nitride. The carbon monoxide is believed to scavenge free fluorine within the plasma to help the selectivity. More particularly, when a compound such as octofluorobutene is used, the plasma can generate both free fluorine and a carbon-fluorine polymer. The carbon monoxide helps scavenge the free fluorine while allowing the fluorocarbon polymer within the plasma to be a passivating agent.

In general, the oxygen released during etching of silica-containing material helps in liberating free fluorine required to continue etching the silica-containing component of the film. However, since oxygen is not introduced as a separate species, the only oxygen present within the plasma will be oxygen released during the etching of the silica-containing component of the material. When a nitride layer is etched, oxygen will not evolve. Therefore, the carbon monoxide scavenges the free fluorine that is present and oxygen is no longer present to allow the further breakup of the octofluorobutene into excessive amounts of free fluorine.

In the foregoing specification, the invention has been described with reference to specific embodiments. However, one of ordinary skill in the art appreciates that various modifications and changes can be made without departing from the scope of the present invention as set forth in the claims below. Accordingly, the specification and figures are to be regarded in an illustrative rather than a restrictive sense, and all such modifications are intended to be included within the scope of present invention.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A process for forming etching an insulating layer (114, 400, 422, 416) characterised by:
forming an insulating layer (114, 400, 422, 416) over a substrate (100); and
etching the insulating layer (114, 400, 422, 416) using an oxide etching component, a fluorine scavenging component, and an organic etching component.

2. The process of claim 1, wherein the oxide etching component includes carbon and oxygen.

3. The process of claim 1, wherein:
the oxide etching component is a fluorocarbon material;
the fluorine scavenging component is carbon monoxide; and
the organic etching component is molecular nitrogen.

4. A process for forming a semiconductor device characterised by:
forming an insulating layer (114, 400, 422, 416) over semiconductor device substrate (100) having a diameter of at least approximately 300 millimeters; and
etching the insulating layer using (114, 400, 422, 416) an oxide etching gas and a nitrogen-containing gas.

5. A process for etching an insulating layer (114, 400, 422, 416) characterised by:
forming an insulating layer (114, 400, 422, 416) over a substrate (100), wherein the insulating layer (114, 400, 422, 416) includes at least one atomic weight percent of an element selected from a group consisting of carbon and hydrogen; and
etching the insulating layer(114, 400, 422, 416), wherein etching is performed using an oxide etching gas and a nitrogen-containing gas.

6. The process of claim 4 or 5, wherein a molecular ratio of the nitrogen-containing gas to the oxide etching gas is in a range of approximately 5:1 to 20:1.

7. The process of claim 1, 2, 3, 4, or 5, wherein a total atomic percent concentration of hydrogen and carbon in the insulating layer is in a range of approximately 5-20%.

8. The process of claim 1, 2, 3, 4, or 5, wherein:
a nitrogen-containing layer (420) underlies the insulating layer (422);
etching defines an opening within the insulating layer and is performed until the nitride layer (420) is exposed.

9. The process of claim 8, wherein:
a metal-containing material (414) underlies the nitrogen-containing layer (420); and
etching the nitrogen-containing layer (420) until the metal-containing material (414) is exposed, wherein no significant portion of the metal-containing material (414) forms along an exposed sidewall surface of the insulating layer (422) during this act.

10. The process of claim 1, 2, 3, 4 or 5, wherein a dielectric constant of the insulating layer (114, 400, 422, 426) is less than approximately 3.5.
